# EUROPÄISCHE PATENTSCHRIFT

(11) **EP 2 045 683 B1**
(45) Veröffentlichungstag und Bekanntmachung des Hinweises auf die Patenterteilung: **10.10.2012**
(21) Anmeldenummer: 08016519.4
(22) Anmeldetag: 19.09.2008
(51) Int. Cl.: G05B 23/02, G05B 9/03, H03K 17/18

(54) **Vorrichtung und Verfahren zur Überprüfung von im Lastkreis einer sicherheitstechnischen Ausgangsschaltung redundant angeschalteten Aktoren**
Method and devices for testing redundant actuators in a safety output circuit
Dispositif et procédé pour tester des actionneurs redondants dans un circuit d'alimentation de sécurité

(30) Priorität: 05.10.2007 DE 102007048122
(43) Veröffentlichungstag der Anmeldung: 08.04.2009
(73) Patentinhaber: Phoenix Contact GmbH & Co. KG, 32825 Blomberg (DE)
(72) Erfinder: Ruth, Olaf, 32825 Blomberg (DE)
(74) Vertreter: Bill, Burkart Hartmut

(56) Entgegenhaltungen:
- EP-A- 0 609 158
- EP-A- 0 665 479
- EP-A- 0 913 938
- EP-A- 1 873 916
- US-B1- 6 297 569

## Beschreibung

Die Erfindung betrifft ein Verfahren und Vorrichtungen zur Überwachung von in einem Lastkreis zum Schalten des Lastkreises in Reihe angeordneten Aktoren.

Zum Ausgeben von sicherheitsrelevanten Signalen an Aktoren, wie beispielsweise Schütze, Motoren, Relais u.s.w., zum Schalten, d.h. zum Aktivieren oder Deaktivieren, eines Lastkreises zum Ausführen einer bestimmten sicherheitstechnischen Applikation werden insbesondere in der Sicherheitstechnik hohe Anforderungen an die Fehlererkennung und das Ausfallverhalten der Schaltung sowie der Peripherie gestellt, die beispielsweise auch den Standards DIN EN 954-1 oder IEC 61508 genügen müssen. Zum Erfüllen dieser Anforderungen sind üblicherweise zweikanalige Strukturen zur Ansteuerung des Lastkreises eingesetzt.

Diese zweikanaligen Strukturen basieren darauf, dass zwei oder mehr Aktoren zur Erzeugung einer sicherheitsrelevanten Redundanz in den Lastkreis eingebunden und applikationsspezifisch angesteuert werden. Zur Überwachung einer ordnungsgemäßen Verschaltung sind in der Regel mit den Aktoren in Verbindung stehende Rücklesekreise vorgesehen. Zum Testen und Überwachen derartiger zweikanaliger Strukturen werden bei bestimmten Zuständen der Aktoren über einen Rücklesekreis entsprechende Rücklesesignale detektiert und ausgewertet.

Müssen zum Durchlaufen bestimmter Tests Steuersignale an die Aktoren ausgeben werden, sind diese häufig am Ausgang sichtbar und können folglich eine angeschaltete Last stören. Dies gilt beispielsweise auch, wenn die Testphase nur recht kurz gehalten wird, da beispielsweise auch bei über den Lastkreis angeschlossenen schnell laufenden Maschinen, bei denen zum Beispiel ein Linear-Motor zum Einsatz kommt, nur wenige Millisekunden erforderlich sind, um deren Endgeschwindigkeit zu erreichen. Folglich erfolgt in solchen Fällen herkömmlicherweise nur ein Test bzw. eine Überwachung vor dem eigentlichen Einsatz der Schaltungsstrukturen und nicht während des Einsatzes zur applikationsspezifisch sicherheitstechnischen Anwendung.

Die EP-A-0 913 938, die EP-A-0 609 158 und die EP-A-0 665 479 zeigen Transistoren als Schaltelemente denen zur Fehlererkennung jeweils Erfassungsmittel, insbesondere Spannungssensoren, parallel geschaltet sind.

Im Einzelnen beschreibt die EP-A-0 913 938 einen statischen Endstellungsunterbrecher zur Steuerung von Hoch- und Mittelspannungsschaltautomaten, welcher zwei Transistoren hat, die in Reihe in den Versorgungskreis einer Steuerspule des Schaltautomaten geschaltet und von einem Mikrosteuerbaustein zum Öffnen oder Schließen ansteuerbar sind. Ferner ist jeweils ein Erfassungsmittel, z. B. ein Spannungssensor, parallel zu den Anschlüssen der zwei Transistoren geschaltet, das ein Kontrollsignal an den Mikrosteuerbaustein sendet. Die EP-A-0 609 158 beschreibt eine fehlersichere Leistungsschnittstelle, die zwischen einer Sicherheitsschnittstelle und einem zu kontrollierenden Aktuator geschaltet werden kann und zwei zwischen einer Spannungsquelle und dem Aktuator in Reihe geschaltete Leistungstransistoren hat, die von einer Steuerung ansteuerbar sind. Ferner umfasst die Leistungsschnittstelle Mittel zur Fehlererkennung, insbesondere Erkennungsschaltkreise, die jeweils parallel zu einem der Transistoren geschaltet sind und in Abhängigkeit vom Zustand des jeweils überwachten Transistors ein Signal an die Steuerung senden. Die EP-A-0 665 479 beschreibt einen zusammengesetzten Sicherheitsschalter zum Schalten einer Verbrauchslast in einer Sicherheitsumgebung, der wenigstens zwei einfache Schalter umfasst, die z. B. in Reihe geschaltet an ihren Anschlüssen jeweils mit einem Element zur Spannungsmessung und einer Steuerschaltung versehen sind.

Der US-B1-6 297 569 lassen sich Relais als Schaltelemente entnehmen, wobei als Erfassungsmittel zur Fehlererkennung Spannungssensoren eingesetzt sind, die mit dem zu überprüfenden Schaltelement hintereinander in Reihe geschaltet sind. Im Einzelnen ist ein Leistungsschaltsystem beschrieben, mit zwei Schaltern in Reihe zwischen einer Spannungsquelle und einer zu schaltenden Last, die über einen Steueranschluss mit einem Signal von einem Mikrocontroller steuerbar sind. Ferner ist jeder Schalter an seinem Ausgang mit einem Spannungssensor verbunden, welcher zur Statusüberwachung ein Signal an den Mikrocontroller überträgt.

Eine wesentliche Aufgabe der Erfindung ist es somit, die Überwachung von Aktoren, an welche sicherheitsrelevante Signale zum Schalten eines zwei- oder mehrkanalig über die Aktoren angesteuerten Lastkreises ausgegeben werden auf einfache Weise und auch sicherheitstechnischen Anforderungen genügend zu im Wesentlichen jeden Zeitpunkt zu ermöglichen, so dass diese auch den Standards DIN EN 954-1 oder IEC 61508 genügt.

Erfindungsgemäße Lösungen der Aufgabe sind durch Gegenstände mit dem Merkmalen nach den unabhängigen Ansprüchen gegeben. Vorteilhafte und/oder bevorzugte Ausgestaltungen und Weiterbildungen sind Gegenstand der weiteren Ansprüche.

Weitere durch die in den Ansprüchen wiedergegebenen Gegenstände gelöste Aufgaben sind darin zu sehen, die Verschaltung als solche und/oder Reaktionszeiten der Aktoren im Feld und zweckmäßigerweise jeweils auch unmittelbar vor Durchführung einer geforderten Sicherheitsfunktion überprüfen zu können.

Die Erfindung schlägt folglich ein Verfahren zum Überprüfen von im Lastkreis einer Ausgangsschaltung zum Schalten des Lastkreises angeordneten Aktoren vor, bei welchem eine Anzahl von Aktoren im Lastkreis in Reihe angeordnet werden, wobei jeder der Aktoren über einen separaten Steuerkanal zur individuellen Ansteuerung mit einer Steuer- und Auswerteeinrichtung (SA) verbunden wird und jedem Aktor ein Hilfskontakt zugeordnet wird, wobei die Hilfskontakte über wenigstens einen Rücklesekreis mit der Steuer- und Auswerteeinrichtung derart verbunden werden, dass nur bei Deaktivierung aller jeweils einem Rücklesekreis zugeordneten Aktoren über diesen Rücklesekreis ein Ruhesignal als Rücklesesignal von der Steuer- und Auswerteeinrichtung erfasst wird, und wobei die Steuer- und Auswerteeinrichtung derart parametriert wird, dass das Ansteuern von in dem Lastkreis in Reihe angeordneten Aktoren zu deren Aktivierung die Schritte umfasst, dass in Bezug auf wenigstens einen Rücklesekreis zunächst immer nur ein zu diesem Rücklesekreis gehörender Aktor aktiviert und das über den diesem Aktor zugeordneten Rücklesekreis erfasste Rücklesesignal ausgewertet wird und zumindest einer von allen in dem Lastkreis in Reihe angeordneten Aktoren zumindest solange deaktiviert bleibt.

Die Erfindung sieht ferner ein Steuer- und Auswertesystem zum Überprüfen von im Lastkreis einer Ausgangsschaltung zum Schalten des Lastkreises in Reihe angeordneten Aktoren vor, welches eine Steuer- und Auswerteeinrichtung umfasst und jeder der Aktoren über einen separaten Steuerkanal zur individuellen Ansteuerung mit der Steuer- und Auswerteeinrichtung verbunden ist und jedem Aktor ein Hilfskontakt zugeordnet ist, wobei die Hilfskontakte über wenigstens einen Rücklesekreis mit der Steuer- und Auswerteeinrichtung verbunden sind.

Die Steuer- und Auswerteeinrichtung ist derart parametriert und/oder parametrierbar, dass, bei in Reihenschaltung angeordneten Aktoren nur bei deaktivierten allen Aktoren, denen ein gemeinsamer Rücklesekreis zugeordnet ist, über diesen ein Ruhesignal als Rücklesesignal von der Steuer- und Auswerteeinrichtung erfassbar ist, beim Ansteuern von in Reihe angeordneten Aktoren zu deren Aktivierung zunächst in Bezug auf wenigstens einen Rücklesekreis immer nur ein zu diesem Rücklesekreis gehörender Aktor aktiviert wird und das über den diesem Aktor zugeordneten Rücklesekreis erfasste Rücklesesignal ausgewertet wird bevor zumindest der letzte der in dem Lastkreis in Reihe angeordneten Aktoren aktiviert werden kann.

Eine Aktivierung der Aktoren wird somit zu wenigstens zwei unterschiedlichen Zeitpunkten bzw. zeitversetzt eingeleitet. Wesentliche Vorteile sind somit bereits darin zu sehen, dass durch die erfindungsgemäßen Lösungen eine Funktionsprüfung einzelner Aktoren separat und zu im Wesentlichen jeder Zeit durchgeführt werden kann ohne dass hierzu notwendige Steuersignale am Ausgang sichtbar sind. Somit ist es möglich, Überprüfungen einer funktionsgerechten Verschaltung implizit, d.h. kontinuierlich während des applikationsspezifischen Einsatzes nach bestimmten Vorgaben, und/oder explizit, d.h. durch bewusstes Einleiten, durchzuführen.

Gemäß erster bevorzugter Ausführungsformen sind die Hilfskontakte, zweckmäßig jeweils zwei Hilfskontakte, in einer Reihenschaltung zur Bildung eines gemeinsamen Rücklesekreises mit der Steuer- und Auswerteeinrichtung verbunden, so dass hierbei auch eine Aktivierung der Aktoren, welchen jeweils ein gemeinsamer Rücklesekreis zugeordnet ist, jeweils zu unterschiedlichen Zeitpunkten eingeleitet wird.

Gemäß zweiter bevorzugter Ausführungsformen wird jeder Hilfskontakt über einen separaten Rücklesekreise mit der Steuer- und Auswerteeinrichtung verbunden, wobei ferner zweckmäßig vorgesehen ist, dass die separaten Rücklesekreise zur Auswertung in Art einer Reihenschaltung miteinander gekoppelt werden können.

Zweckmäßig ist ferner eine Parametrierung der Steuer- und Auswerteeinrichtung, gemäß welcher bei geforderter Aktivierung aller Aktoren vor der Aktivierung aller Aktoren und/oder bei nicht geforderter Aktivierung aller Aktoren stets zumindest ein Aktor deaktiviert bleibt und wobei in Bezug auf wenigstens einen Rücklesekreis jeweils lediglich ein zu diesem Rücklesekreis gehörender Aktor abwechselnd zur Aktivierung und Deaktivierung angesteuert wird, wobei währenddessen alle weiteren zu diesem Rücklesekreis gehörenden Aktoren deaktiviert bleiben und das entsprechend über den Rücklesekreis erfasste Rücklesesignal ausgewertet wird. Sind die Hilfskontakte jeweils über einen separaten Rücklesekreise angeschaltet, ist somit die Anzahl von weiteren zu dem entsprechenden Rücklesekreis gehörenden Aktoren gleich Null. Da auch bei diesen Ausführungsformen stets zumindest ein Aktor deaktiviert bleibt, können Prüfsequenzen in Bezug auf ausgewählte Aktoren nicht nur hinsichtlich deren Anschaltfunktionalität sondern auch hinsichtlich deren Abschaltfunktionalität durchlaufen werden ohne, dass ein Signal am Ausgang sichtbar ist.

Um den Verschleiß der Aktoren möglichst gering zu halten, wird zweckmäßig bei jedem geforderten Aktivierungsvorgang aller in dem Lastkreis in Reihe geschalteten Aktoren mit der Aktivierung eines Aktors abgeschlossen, der beim vorangegangen Aktivierungsvorgang aller Aktoren nicht der letzte war, der hierzu aktiviert wurde. Sind lediglich zwei Aktoren vorhanden, wird somit jeder der Aktoren abwechselnd und somit gleichmäßig belastet.

Weiterbildungen sehen überdies vor, in Bezug auf wenigstens einen Rücklesekreis beim jeweiligen Aktivieren lediglich eines zu einem Rücklesekreis gehörenden Aktors und/oder beim Abschalten aller zu einem gemeinsamen Rückleskreis gehörender Aktoren die Reaktionszeit eines über den entsprechenden Rücklesekreis erfassten Signalwechsels mit einem vordefinierten Zeitfensters zu vergleichen. Das Steuer- und Auswertesystem umfasst hierzu eine entsprechend ausgebildete Vergleichseinrichtung.

Weiterhin von Vorteil ist, dass das Steuer- und Auswertesystem nach der Erfindung die Steuer- und Auswerteeinrichtung, der Rücklesekreis und die Aktoren in einem Gehäuse integriert und/oder einzelne miteinander verbundene Moduleinheiten umfasst.

Insbesondere ist bzw. wird die Steuer- und Auswerteeinrichtung derart parametriert, dass in Bezug auf wenigstens einen Rücklesekreis beim jeweiligen Aktivieren lediglich eines zu einem Rücklesekreis gehörenden Aktors und/oder beim Abschalten aller zu einem gemeinsamen Rückleskreis gehörender Aktoren das über den entsprechenden Rücklesekreis erfasste Rücklesesignal ausgewertet wird.

Von Vorteil ist ferner, wenn die Steuer-Auswerteeinrichtung von extern zur Einleitung wenigstens eines Aktivierungsvorgangs ansteuerbar ist.

Durch die Erfindung erzielte Vorteile sind folglich auch darin zu sehen, dass die Verschaltung als solche und/oder Reaktionszeiten der Aktoren im Feld und zweckmäßig jeweils auch unmittelbar vor Durchführung einer geforderten Sicherheitsfunktion überprüft werden können. Durch die Erfindung ist somit ferner auf einfache Weise ermöglicht, die Aktoren auf funktionsgerechtes Steuerverhalten zu im Wesentlichen jedem Zeitpunkt sicher zu überprüfen.

Unzulässige Verschaltungen einschließlich Verdrahtungsfehler sowie unzulässige Reaktionszeiten, insbesondere Abschaltzeiten, können somit äußerst zuverlässig vor einer jeweils nächsten Sicherheitsanforderung erkannt und entsprechende Reaktionen können somit frühzeitig eingeleitet werden, z.B. den Lastkreis in einen sicheren Zustand zu bringen.

Ein weiterer Vorteil besteht darin, dass die parametrierbare Steuer- und Auswerteeinrichtung applikationsspezifisch somit eine Mehrzahl von unterschiedlichen Testzyklen bzw. -sequenzen zum Prüfen jedes der Aktoren durchlaufen kann, und folglich die erfindungsgemäße Schaltung einen flexiblen, vielseitigen Einsatz auch bei unterschiedlichen Umgebungsbedingungen ermöglicht.

Die Gegenstände nach der Erfindung sind folglich bevorzugt in der Sicherheitstechnik einsetzbar und/oder werden zum Steuern eines Aktorschutzschaltelements, z.B. eines Relais, Schützes oder Motors verwendet.

Zusammenfassend kann somit insbesondere als vorteilhaft festgehalten werden, dass eine Funktionsprüfung der Aktoren jeweils einzeln und vor dem Aktivieren aller zum Schalten der Last notwendigen Aktoren ermöglicht wird, dass Verdrahtungsüberprüfungen implizit, d.h. zu im Wesentlichen jedem Zeitpunkt, oder explizit, d.h. durch bewusstes Aktivieren einer Testsequenz, durchführbar sind, dass Verdrahtungsfehler vor der jeweils nächstfolgenden Sicherheitsanforderung, d.h. vor dem jeweils nächsten erforderlichen Schalten der Last, erkannt werden können und, dass ferner unzulässige Abschaltzeiten vor der jeweils nächstfolgenden Sicherheitsanforderung erkannt werden können.

Die Erfindung wird nachfolgend anhand einer bevorzugten Ausführungsform unter Bezugnahme auf die beigefügten Zeichnungen näher beschrieben. In den Zeichnungen zeigen:
- Fig. 1: einen Aufbau einer beispielhaften Anordnung eines Steuer- und Auswertesystems nach der Erfindung,
- Fig. 2: ein beispielhaftes Ablaufdiagram von erfindungsgemäßen Prüfsequenzen bei fehlerfreiem Betrieb basierend auf einer Anordnung nach Fig. 1,
- Fig. 3: einen weiteren Aufbau einer beispielhaften Anordnung eines Steuer- und Auswertesystems nach der Erfindung, und
- Fig. 4: ein beispielhaftes Ablaufdiagram von erfindungsgemäßen Prüfsequenzen bei fehlerfreiem Betrieb basierend auf einer Anordnung nach Fig. 3.

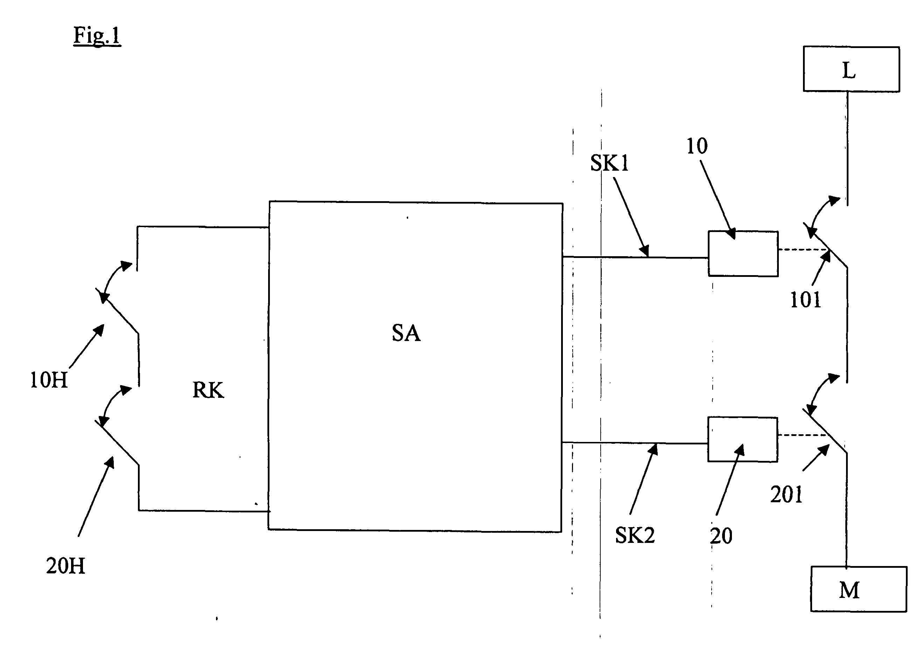

Nachfolgend wird zunächst auf Figur 1 Bezug genommen, welche im dargestellten Beispiel eine erste erfindungsgemäße Anordnung eines Steuer- und Auswertesystems zum Ausgeben von sicherheitsrelevanten Signalen an zwei Aktoren zum Schalten eines über diese Aktoren zweikanalig anzusteuernden Lastkreises einer im weiteren nicht dargestellten Ausgangsschaltung zeigt.

Der Lastkreis umfasst einen Motor M und eine über einen Signalweg an diesen elektrisch anschaltbare Last L. In den hierzu zu schließenden Signalweg sind zwei Aktoren in Reihe angeordnet, wobei jeder Aktor im vorliegenden Beispiel eine Treibereinheit, z.B. Schützspulen 10 oder 20, und Schließmittel, z.B. Schützkontakte 101 bzw. 201 besitzt. Wird die Spule 10 oder 20 aktiviert, schließen die Schützkontakte 101 bzw. 201. Aufgrund der Reihenanordnung innerhalb des Lastkreises wird die Last L jedoch erst elektrisch mit dem Motor M verbunden und also der Signalweg geschlossen, wenn beide Spulen 10 und 20 aktiviert und also alle Schützkontakte geschlossen sind. Andernfalls ist der Signalweg unterbrochen und die Last deaktiviert. Ist der zu schließende Signalweg mehrphasig ausgebildet, besitzt jeder Aktor zweckmäßig auch eine entsprechende Anzahl von Schließmitteln.

Das Steuer- und Auswertesystem umfasst ferner eine Steuer- und Auswerteeinrichtung SA, welche zwei Steuerkanäle SK1 und SK2 besitzt, wobei jede Treibereinheit 10 und 20 separat über einen Steuerkanal SK1 bzw. SK2 zur Ansteuerung durch die Steuer- und Auswerteeinrichtung mit dieser verbunden ist.

Jeder Aktor besitzt ferner jeweils einen der Treibereinheit 10 oder 20 zugeordneten Hilfskontakt 10H bzw. 20H, die über eine Reihenschaltung an die Steuer- und Auswerteeinrichtung angeschaltet sind und einen gemeinsamen Rücklesekreis RK bilden. Bei ordnungsgemäßer Anschaltung der Hilfskontakte 10H und 20H mit der Steuer- und Auswerteeinrichtung SA sind diese mit der Treibereinheit 10 bzw. 20 über die Steuer- und Auswerteeinrichtung verschaltet und die Steuer- und Auswerteeinrichtung ist parametriert, dass in dem Fall, wenn beide Aktoren nicht aktiviert sind, über den Rücklesekreis ein Ruhesignal, z.B. in Form eines Ruhestroms, von der Steuer- und Auswerteeinrichtung erfassbar ist.

Wird wenigstens ein Aktor 10 oder 20 aktiviert und also von der Steuer- und Auswerteeinrichtung entsprechend angesteuert, ist über den Rücklesekreis ein Signalwechsel von der Steuer- und Auswerteeinrichtung erfassbar, z.B. öffnet sich dann der entsprechend zugeordnete Hilfskontakt 10H bzw. 20H, so dass über den Rücklesekreis kein Signal mehr bzw. ein Nullsignal anliegt. Entsprechend erfolgt ein Signalwechsel in umgekehrter Richtung, d.h. wenn der letzte Aktor, der dem Rücklesekreis zugeordnet ist deaktiviert wird. Bei fehlerfreien Betrieb bzw. Funktion der Aktoren erfolgt ein solcher Signalwechsel ferner jeweils innerhalb einer vorbestimmten Zeit. Die Steuer- und Auswerteeinheit SA besitzt daher zweckmäßig eine bei Fig. 1 nicht explizit dargestellte Vergleichseinrichtung, welche die Reaktionszeiten für einen geforderten Signalwechsel mit vorbestimmten Zeiten bzw. Zeitfenstern vergleicht.

Das Überwachen, und also das Prüfen bzw. Testen der Aktoren, denen ein gemeinsamer Rücklesekreises zugeordnet ist, einschließlich der Verschaltung erfolgt, indem die Treibereinheiten 10 und 20 der Aktoren zeitversetzt, d.h. nie zeitgleich, und bevorzugt wechselseitig aktiviert werden, so dass auch vor jeder nächsten Sicherheitsanforderung, d.h. wenn alle zu einem Rücklesekreis gehhörenden Aktoren aktiviert sind, eine Überwachung erfolgt. Um hierbei alle Aktoren zu überprüfen, ist es daher zweckmäßig jeweils für zwei Aktoren einen gemeinsamen Rücklesekreis zu verschalten. Dadurch kann zum Einen eine Diagnose mit hundertprozentiger Fehleraufdeckung im Rücklesekreis der Schaltung realisiert werden ohne zu negativen Einwirkungen auf die Last zu führen und andererseits wird der Verschleiß aufgrund eines wechselseitigen Einschaltens gleichmäßig verteilt.

Die an und für sich parametrierbare Steuer- und Auswerteeinrichtung SA ist nunmehr derart parametrierbar, dass definierte Sequenzen zum sicheren Überwachen der Aktoren, d.h. der Verschaltung der Aktoren einschließlich der jeweiligen Anschaltung gemeinsamer Rücklesekreise sowie der Reaktionszeiten der Aktoren in Folge deren Aktivierung und/oder Deaktivierung, zu im wesentlichen jedem Zeitpunkt durchlaufen werden können ohne, dass dies am Ausgang und also am Lastkreis sichtbar wird. Führt die Überwachung zu einer Fehlererkennung, können zeitnah der jeweiligen Applikation und Sicherheitsanforderung entsprechend Reaktionen und Maßnahmen eingeleitet werden.

Das Durchlaufen definierter Sequenzen kann fest in der Steuer- und Auswerteeinrichtung parametriert sein, so dass diese Sequenzen z.B. implizit während des bestimmungsgemäßen Einsatzes der Aktoren durchlaufen werden. Das Parametrieren der Steuer- und Auswerteeinrichtung zum Durchlaufen definierter Sequenzen und/oder das Einleiten definierter Sequenzen kann jedoch auch z.B. über eine modular mit der Steuer- und Auswerteeinrichtung verbindbare weitere Einheit, z.B. eine FB-Instanz, erfolgen, so dass bestimmte zu durchlaufende Sequenzen z.B. auch explizit, also bewusst vorgegeben oder angewählt werden können.

Dies ist somit besonders zweckmäßig, wenn die bei Fig.1 gezeigten Komponenten zwar gegebenenfalls in einem Gehäuse integriert sind, jedoch grundsätzlich modular zusammengebaut sind.

So können, wie nachfolgend anhand beispielhafter Sequenzen aufgezeigt, Fehler in der Verdrahtung, z.B. bei nicht oder falsch verdrahteten oder auch überbrückten Hilfskontakten, einfach erkannt werden. Ferner werden durch Anwendung der Erfindung Fehler in der übrigen Peripherie, also z.B. aufgrund von vom Lastzweig abgekoppelten Aktoren auf einfache Weise erkannt. Auch Manipulationen im Rücklesekreis können umgehend aufgedeckt werden. Das Risiko, dass solche Fehler unentdeckt bleiben, und der Verlust der geforderten Sicherheitsfunktion durch einen Common-Cause-Fehler sind somit im Wesentlichen ausgeschlossen.

Nachfolgend werden drei bevorzugte Sequenzen zum Überwachen der Aktoren des zweikanalig angeschalteten sicherheitstechnischen Lastkreises basierend auf voraufgezeigter Ausbildung der Erfindung beschrieben. Allgemein gilt hierbei grundsätzlich, dass bei Erkennen eines Fehlers der Lastkreis in der Regel in einen sicheren Zustand gefahren wird, welches jedoch nicht näher ausgeführt wird.

Bei einem ersten Verfahren zur Überwachung der Aktoren ist ein noch niedriges Sicherheitsniveau maßgebend.

Zunächst sind beide Treibereinheiten 10 und 20 im abgeschalteten und also nicht angesteuerten Zustand. Ein solcher Zustand wird nachfolgend der Einfachheit halber als "OFF" bezeichnet. Wie vorstehend ausgeführt, ist in dem Fall, wenn beide Treibereinheiten 10 und 20 nicht angesteuert sind und die Aktoren also nicht aktiviert sind, über den Rücklesekreis ein Ruhesignal erfassbar. Ein solcher Zustand des Rücklesesignals wird nachfolgend der Einfachheit halber als "TRUE" bezeichnet.

Wird eine Treibereinheit angesteuert und der Aktor somit aktiviert, wird nachfolgend dieser Zustand der Einfachheit halber als "ON" bezeichnet. In diesem Fall erfolgt ferner bei Fehlerfreiheit ein Signalwechsel über den Rücklesekreis und ein nachfolgend als "FALSE" bezeichneter Signalzustand ist somit erfassbar.

Ein Signalwechsel von "TRUE" auf "FALSE" muss sich bei Fehlerfreiheit also immer dann einstellen, wenn zunächst beide Aktoren auf "OFF" sind und ein Aktor für den Zustand "ON" angesteuert wird. Umgedreht muss sich ein Signalwechsel von "FALSE" auf "TRUE" bei Fehlerfreiheit immer dann einstellen, wenn zunächst zumindest ein Aktor für den Zustand "ON" angesteuert wird und dann beide Aktoren auf "OFF" fallengelassen werden.

Zusätzlich sollten diese Signalwechsel innerhalb vorgegebener Reaktionszeiten erfolgen, so dass durch die Erfindung bevorzugt auch eine maximal zulässige Reaktionszeit für den fehlerfreien Betreib überwacht wird. Anwendungsbedingt ist folglich bevorzugt zumindest die Überwachung der Reaktionszeit in Abhängigkeit innerhalb eines definierten Zeitfensters vorgesehen, wenn zunächst alle zu einem Rücklesekreis gehörenden Aktoren auf "OFF" sind und dann einer dieser Aktoren für den Zustand "ON" angesteuert wird oder, wenn zunächst zumindest einer der zu einem Rücklesekreis gehörenden Aktoren für den Zustand "ON" angesteuert wird und dann alle dieser Aktoren auf "OFF" fallengelassen werden.

Bei dem ersten Verfahren sind somit zunächst beide Treibereinheiten 10 und 20 "OFF" und das Rücklesesignal ist "TRUE".

Es sei nun angenommen, dass die angeschaltete Last L aktiviert werden soll und also die entsprechende Sicherheitsfunktion der Aktoren angefordert wird, und folglich beide Aktoren aktiviert werden müssen.

Wie zuvor beschrieben, wird der Einschaltvorgang zeitversetzt und bevorzugt wechselseitig durchgeführt, d.h. bei dieser bevorstehenden Anforderung wird zunächst z.B. die Treibereinheit 10 als erstes angesteuert, bei der nächsten Anforderung aus einem gemeinsamen "OFF"-Zustand zunächst die Treibereinheit 20.

Es sei angenommen, die Treibereinheit wechselt von "OFF" auf "ON". Folglich muss das Rücklesesignal von "TRUE" auf "FALSE" wechseln. Wird die maximal zulässige Reaktionszeit überschritten, ist der entsprechende Aktor fehlerbehaftet. Erfolgt kein Wechsel des Zustandes des Rücklesekreises ist die Verdrahtung fehlerbehaftet. In beiden Fällen wird auf Fehler erkannt.

Anschließend wird bei fehlerfreiem Betrieb die Treibereinheit 20 von "OFF" auf "ON" gesetzt. Das Rücklesesignal bleibt also auf "FALSE". Nach Beendigung der Anforderung an die Sicherheitsfunktion werden beide Aktoren auf "OFF" gesetzt und das Rücklesesignal (RS) muss folglich auf "ON" wechseln.

In diesem Zustand kann optional jeder Aktor und dessen Verschaltung separat geprüft werden. Bei der nächsten Anforderung an die Sicherheitsfunktion wird zunächst die Treibereinheit 20 als erstes angesteuert.

Zusammenfassend ergibt sich z.B. folgende Prüfsequenz, wobei bei fehlerfreiem Betrieb die jeweils nächste Sequenz eingeleitet wird und andernfalls auf Fehler erkannt wird.

| Sequenz | 10 | 20 | RS | Kommentar |
|---|---|---|---|---|
| 1 | OFF | OFF | TRUE | Beide Aktoren aus |
| 2 | ON oder OFF | OFF ON | FALSE FALSE | Anforderung an Sicherheitsfunktion : beide Aktoren einschalten; jedoch zeitversetzt und bevorzugt bei jeder Anforderung die Reihenfolge wechseln |
| 3 | ON | ON | FALSE | Beide Aktoren an |
| 4 | OFF | OFF | TRUE | Beide Aktoren aus |
| 5 | ON OFF | OFF ON | FALSE | Aktoren werden optional wechselseitig ein- und wieder ausgeschaltet, wobei einer stets ausgeschaltet bleibt |

Mit anderen Worten wird hierbei vor dem Einschalten beider Aktoren zumindest einer noch einmal separat auf Fehlerfreiheit hinsichtlich der Anschaltfunktionalität hin geprüft.

Bei einem zweiten Verfahren zur Überprüfung der angeschlossenen Aktoren ist ein mittleres Sicherheitsniveau maßgebend. Soll die Last L aktiviert werden, wird in Abwandlung zum ersten Verfahren ein Aktor für "ON" und bei fehlerfreiem Betrieb wieder für "OFF" angesteuert und anschließend der andere Aktor auf "ON" und bei fehlerfreiem Betrieb der erste Aktor zusätzlich auf "ON" gesetzt. Nach Beendigung der Sicherheitsanforderung werden beide Aktoren wieder auf "OFF" fallengelassen. Zusammenfassend ergibt sich z.B. folgende Prüfsequenz, wobei bei fehlerfreiem Betrieb die jeweils nächste Sequenz eingeleitet wird und andernfalls auf Fehler erkannt wird.

| Sequenz | 10 | 20 | RS | Kommentar |
|---|---|---|---|---|
| 1 | OFF | OFF | TRUE | Beide Aktoren aus |
| 2-a | ON | OFF | FALSE | Anforderung an Sicherheitsfunktion beide Aktoren einschalten; jedoch werden bei jedem Einschaltvorgang beide Aktoren auf deren Aktivierung hin separat geprüft |
| 2-b | OFF | OFF | TRUE | |
| 2-c | OFF | ON | FALSE | Die Sequenz 2-a bis 2-c werden optional bei jedem Einschaltvorgang gewechselt |
| 3 | ON | ON | FALSE | Beide Aktoren an |
| 4 | OFF | OFF | TRUE | Beide Aktoren aus |
| 5 | ON OFF | OFF ON | FALSE | Aktoren werden optional wechselseitig ein- und wieder ausgeschaltet, wobei einer stets ausgeschaltet bleibt |

Mit anderen Worten werden hierbei vor dem Einschalten beider Aktoren diese noch einmal jeweils separat auf Fehlerfreiheit hinsichtlich der Anschaltfunktionalität hin geprüft.

Bei einem dritten Verfahren zur Überprüfung der angeschlossenen Aktoren ist ein hohes Sicherheitsniveau maßgebend.

Zunächst sind beide Treibereinheiten 10 und 20 wiederum auf "OFF". Soll die Last L aktiviert werden, wird in weiterer Abwandlung ein Aktor auf "ON", bei fehlerfreiem Betrieb wieder auf "OFF" und anschließend" der andere Aktor auf "ON" und bei fehlerfreiem Betrieb zunächst auch wieder auf "OFF" gesetzt. Erst anschließend wird der Einschaltvorgang beider Aktoren wechselseitig eingeleitet.

Nach Beendigung der Sicherheitsanforderung werden beide Aktoren wieder auf "OFF" fallengelassen.

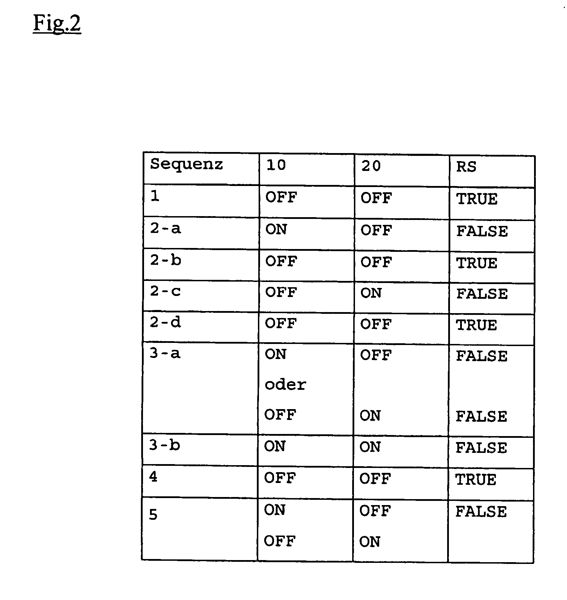

Zusammenfassend ergibt sich z.B. folgende, auch in Fig. 2 dargestellte Prüfsequenz, wobei bei fehlerfreiem Betrieb die jeweils nächste Sequenz eingeleitet wird und andernfalls auf Fehler erkannt wird.

| Sequenz | 10 | 20 | RS | Kommentar |
|---|---|---|---|---|
| 1 | OFF | OFF | TRUE | Beide Aktoren aus |
| 2-a | ON | OFF | FALSE | Anforderung an Sicherheitsfunktion : beide Aktoren einschalten; jedoch bei werden bei jedem Einschaltvorgang beide Aktoren auf deren Aktivierung und Deaktivierung hin separat geprüft |
| 2-b | OFF | OFF | TRUE | |
| 2-c | OFF | ON | FALSE | Die Sequenz 2-a bis 2-d werden optional bei jedem Einschaltvorgang gewechselt |
| 2-d | OFF | OFF | TRUE | |
| 3-a | ON oder OFF | OFF ON | FALSE FALSE | Aktoren einschalten, jedoch bei jedem Einschaltvorgang die Reihenfolge wechseln |
| 3-b | ON | ON | FALSE | Beide Aktoren an |
| 4 | OFF | OFF | TRUE | Beide Aktoren aus |
| 5 | ON OFF | OFF ON | FALSE | Aktoren werden optional wechselseitig ein- und wieder ausgeschaltet, wobei einer stets ausgeschaltet bleibt |

Mit anderen Worten werden hierbei vor dem Einschalten beider Aktoren diese noch einmal jeweils separat auf Fehlerfreiheit sowohl hinsichtlich der Anschaltfunktionalität als hinsichtlich der Abschaltfunktionalität hin geprüft. Hierdurch wird vor der Durchführung einer angeforderten Sicherheitsfunktion wirklich jeder auftretender Fehler einschließlich bei der Abschaltzeit erkannt.

Grundsätzlich sichert jedoch die (optionale) zyklische Prüfung der Abschaltzeit der angeschlossen Aktoren die in einer sicherheitstechnischen Applikation notwendige Reaktionszeit ab. Durch eine definiert wechselnde Einschaltreihenfolge bei der Anforderung an die Sicherheitsfunktion wird der Verschleiß beim Einschaltvorgang gleichmäßig auf die Aktoren verteilt. Unter Anwendung der Erfindung kann somit im Wesentlichen auf Fehlerausschlüsse verzichtet werden, so dass durch den hohen sicherheitstechnischen Diagnosegrad ein Einsatz für Aktoren im Feld oder im Schaltschrank ohne weitere Maßnahmen ermöglicht ist.

Es ist für den Fachmann ersichtlich, dass die Parametrierung nach der Erfindung grundsätzlich in Hardware und/oder in Software erfolgen kann.

Auch müssen die Aktoren nicht erst beide eingeschaltet werden, um einen Fehler zu erkennen, welches z.B. einen wesentlichen Vorteil gegenüber der TC5-PLCopen-Spezifikation bzw. EDM-Funktionsbausteinen bietet. Ferner ist der Aufbau eines modularen Systems, auch mit unterschiedlichen Sicherheitsniveaus, einschließlich einer explizit anwählbaren Verdrahtungsüberprüfung möglich. Darüber hinaus kann stets eine implizite Verdrahtungsüberprüfung gewährleistet werden. Ein hierzu bisher notwendiger, bewusster Fehlereinbau und wieder - ausbau entfällt. Trotz der scheinbar kritischen Reihenschaltung im Rücklesekreis ist eine ortsgenaue Diagnose von dort auftretenden Fehlern sichergestellt und bisher unerkannt gebliebene Fehler werden sicher aufgedeckt.

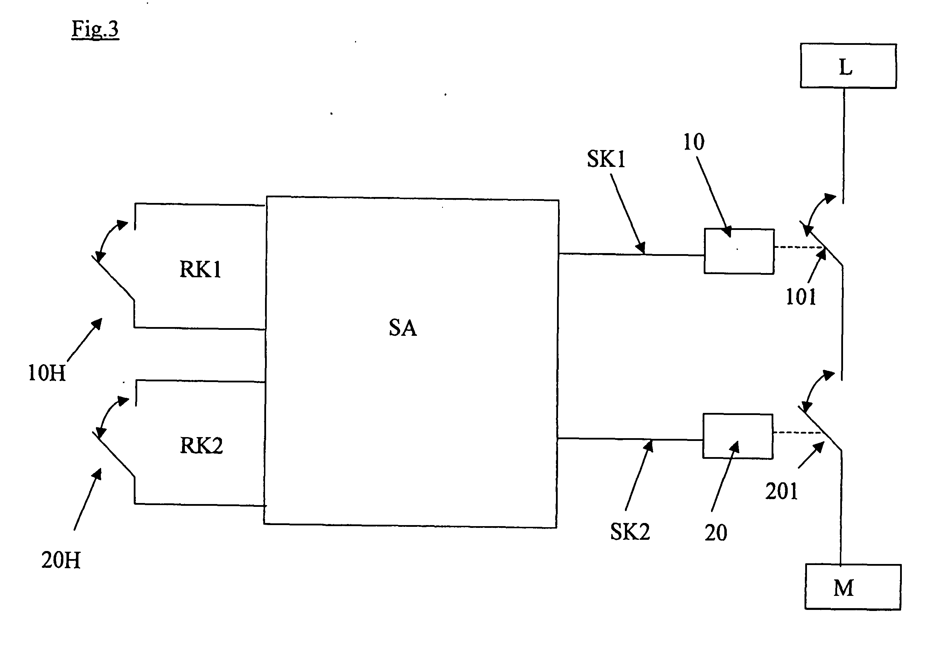

Nachfolgend wird nun auf Figur 3 Bezug genommen, welche im dargestellten Beispiel eine weitere erfindungsgemäße Anordnung. Die Bezugszeichen für einander im Wesentlichen entsprechende Komponenten wurden der Einfachheit halber beibehalten. Auf die Abwandlungen in Bezug auf die in Fig. 1 beschriebene Ausführungsform wird nachfolgend eingegangen.

In einer Abwandlung zu Fig. 1 besitzt jeder Aktor gemäß Fig. 3 einen der Treibereinheit 10 oder 20 zugeordneten Hilfskontakt 10H bzw. 20H, die nunmehr jeweils über einen eigenen Rücklesekreis RK1 bzw. RK2 an die Steuer- und Auswerteeinrichtung angeschaltet sind. Zwar müssen hierzu eine der erhöhten Anzahl von Rücklesekreisen entsprechende erhöhte Anzahl von Schnittstellen bei der Steuer- und Auswerteeinrichtung vorgesehen sein, andererseits kann anwendungsbedingt diese dann auch ausgebildet und/oder parametriert sein, die jeweiligen eigenen Rücklesekreise RK1 und RK2 anhand deren separater Rücklesesignale, nachfolgend auch als RS1 und RS2 bezeichnet, auszuwerten oder mittels eines gemeinsames Rücklesesignals durch Auswertung der Rücklesekreise RK1 und RK2 mit einer durch die Steuer- und Auswerteeinrichtung SA bereitgestellten Reihenschaltung. Die Rücklesekreise werden somit in Art einer Reihenschaltung miteinander gekoppelt. Bei ordnungsgemäßer Anschaltung der Hilfskontakte 10H und 20H mit der Steuer- und Auswerteeinrichtung SA sind diese mit der Treibereinheit 10 bzw. 20 somit verbunden, dass über einen Rücklesekreis ein Ruhesignal erfassbar ist, wenn der entsprechende Aktor nicht aktiviert ist. Auch bei diesen Ausführungsformen in Bezug auf wenigstens einen Rücklesekreis ist zunächst immer nur ein zu diesem Rücklesekreis gehörender Aktor 10, 101 oder 20, 201 aktiviert und das über den diesem Aktor zugeordneten Rücklesekreis RK1 oder RK2 erfasste Rücklesesignal wird ausgewertet, wobei zumindest einer von allen in dem Lastkreis in Reihe angeordneten Aktoren zumindest solange deaktiviert bleibt. Ist der Aktor 10, 101 aktiviert bleibt folglich der Aktor 20, 201 zumindest bis zur erfolgten Auswertung deaktiviert und umgekehrt.

Ferner ist, wenn der Aktor 10, 101 oder 20, 201 aktiviert und also von der Steuer- und Auswerteeinrichtung entsprechend angesteuert wird, über den entsprechenden Rücklesekreis RK1 bzw. RK2 ein Signalwechsel von der Steuer- und Auswerteeinrichtung erfassbar. Entsprechend erfolgt ein Signalwechsel in umgekehrter Richtung im Gegensatz zur Fig. 1 bei jeder Deaktivierung eines Aktors.

Die an und für sich parametrierbare Steuer- und Auswerteeinrichtung SA ist folglich nunmehr auch derart parametrierbar, dass zusätzlich zur vorstehend aufgeführten Aktorüberwachung mit Bezug auf Fig. 1 definierte Sequenzen noch eine erweiterte Verdrahtungsprüfung ermöglichen, insbesondere im Bereich einer Spulenverdrahtung, da jedem Aktor ein eigenes Rücklesesignal in der Steuer- und Auswerteeinheit zugeordnet werden kann.

So können z.B. ferner Fehler in der Hardware im Signalweg zur Ansteuerung von Spulen (wie Leiterkurzschluss, Querschluss, Common Cause) erkannt werden sowie Fehler in Folge von Manipulation bei der Ansteuerung von Spulen oder Fehler, welche sich während des operativen Einsatzes im Signalweg zur Ansteuerung ergeben. Da Fehler bei der Ansteuerung erkannt werden, ist der Aufwand bei der Validation einer Sicherheitsfunktion durch den Anwender nochmals verringert und eine Auswertung über getrennte Rücklesesignale ermöglicht eine noch genauere Diagnose in Richtung des Anwenders.

Nachfolgend werden wiederum drei bevorzugte Sequenzen, jedoch für eine Anordnung nach Fig. 3 beschrieben.

Bei einem ersten Verfahren ist wiederum das noch niedrige Sicherheitsniveau maßgebend und zunächst sind beide Treibereinheiten 10 und 20 wieder im "OFF"-Zustand und beide Rücklesesignale RS1 und RS2 auf "TRUE". In Abwandlung stellt sich somit ein Signalwechsel von "TRUE" auf "FALSE" in Bezug auf jedes Rücklesesignal bei Fehlerfreiheit immer dann ein, wenn der entsprechend zugehörige Aktor von "OFF" auf "ON" angesteuert wird. Umgedreht muss sich ein Signalwechsel von "FALSE" auf "TRUE" bei Fehlerfreiheit immer dann in Bezug ein Rücklesesignal einstellen, wenn der entsprechende Aktor von "ON" auf "OFF" fallengelassen wird.

Es sei angenommen, die Treibereinheit 10 wechselt von "OFF" auf "ON". Folglich muss das Rücklesesignal RS1 des Rücklesekreises RK1 von "TRUE" auf "FALSE" wechseln. Anschließend wird bei fehlerfreiem Betrieb die Treibereinheit 20 von "OFF" auf "ON" gesetzt. Das Rücklesesignal RS1 bleibt also auf "FALSE" und das Rücklesesignal RS2 des Rücklesekreises RK2 muss von "TRUE" auf "FALSE" wechseln. Nach Beendigung der Anforderung an die Sicherheitsfunktion werden beide Aktoren auf "OFF" gesetzt und beide Rücklesesignale müssen folglich auf "ON" wechseln. Zusammenfassend ergibt sich somit in Abwandlung z.B. folgende Prüfsequenz, wobei bei fehlerfreiem Betrieb die jeweils nächste Sequenz eingeleitet wird und andernfalls auf Fehler erkannt wird.

| Sequenz | 10 | 20 | RS1 | RS2 | Kommentar |
|---|---|---|---|---|---|
| 1 | OFF | OFF | TRUE | TRUE | Beide Aktoren aus |
| 2 | ON oder OFF | OFF ON | FALSE | TRUE FALSE | Anforderung an Sicherheitsfunkti on: beide Aktoren einschalten; jedoch zeitversetzt und bevorzugt bei jeder Anforderung die Reihenfolge wechseln |
| 3 | ON | ON | FALSE | FALSE | Beide Aktoren an |
| 4 | OFF | OFF | TRUE | TRUE | Beide Aktoren aus |
| 5 | ON OFF | OFF ON | FALSE TRUE | TRUE FALSE | Aktoren werden optional wechselseitig ein- und wieder ausgeschaltet, wobei einer stets ausgeschaltet bleibt |

Bei einem zweiten Verfahren ist wiederum das mittlere Sicherheitsniveau maßgebend und zusammenfassend ergibt sich somit in Abwandlung z.B. folgende Prüfsequenz.

| Sequenz | 10 | 20 | RS1 | RS1 | Kommentar |
|---|---|---|---|---|---|
| 1 | OFF | OFF | TRUE | TRUE | Beide Aktoren aus |
| 2-a | ON | OFF | FALSE | TRUE | Anforderung an Sicherheitsfunkti on: beide Aktoren einschalten; jedoch werden bei jedem Einschaltvorgang beide Aktoren auf deren Aktivierung hin separat geprüft |
| 2-b | OFF | OFF | TRUE | TRUE | |
| 2-c | OFF | ON | TRUE | FALSE | Die Sequenz 2-a bis 2-c werden optional bei jedem Einschaltvorgang gewechselt |
| 3 | ON | ON | FALS E | FALSE | Beide Aktoren an |
| 4 | OFF | OFF | TRUE | TRUE | Beide Aktoren aus |
| 5 | ON OFF | OFF ON | FALSE TRUE | TRUE FALSE | Aktoren werden optional wechselseitig ein- und wieder ausgeschaltet, wobei einer stets ausgeschaltet bleibt |

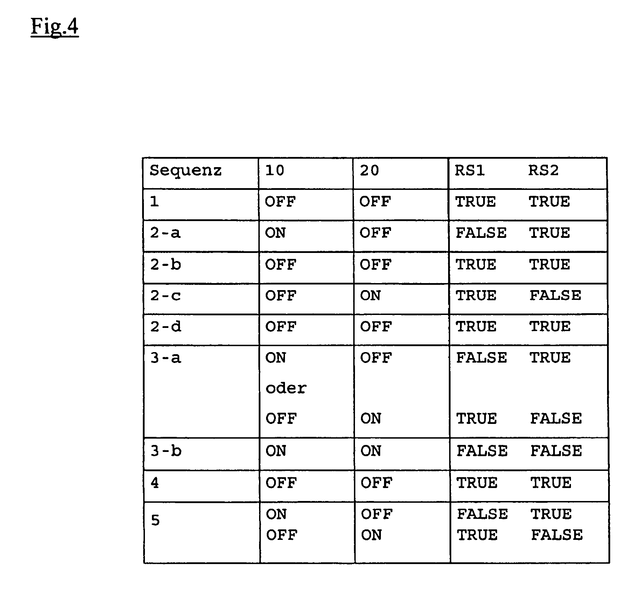

Bei einem dritten abgewandelten Verfahren ist wiederum das hohe Sicherheitsniveau maßgebend und zusammenfassend ergibt sich somit in Abwandlung z.B. folgende, auch bei Fig. 4 dargestellte Prüfsequenz.

| Sequenz | 10 | 20 | RS1 | RS2 | Kommentar |
|---|---|---|---|---|---|
| 1 | OFF | OFF | TRUE | TRUE | Beide Aktoren aus |
| 2-a | ON | OFF | FALSE | TRUE | Anforderung an Sicherheitsfunktion: beide Aktoren einschalten; jedoch bei werden bei jedem Einschaltvorgang beide Aktoren auf deren Aktivierung und Deaktivierung hin separat geprüft |
| 2-b | OFF | OFF | TRUE | TRUE | |
| 2-c | OFF | ON | TRUE | FALSE | Die Sequenz 2-a bis 2-d werden optional bei jedem Einschaltvorgang gewechselt |
| 2-d | OFF | OFF | TRUE | TRUE | |
| 3-a | ON oder OFF | OF F ON | FALSE TRUE | TRUE FALSE | Aktoren einschalten, jedoch bei jedem Einschaltvorgang die Reihenfolge wechseln |
| 3-b | ON | ON | FALS E | FALSE | Beide Aktoren an |
| 4 | OFF | OFF | TRUE | TRUE | Beide Aktoren aus |
| 5 | ON OFF | OFF ON | FALSE TRUE | TRUE FALSE | Aktoren werden optional wechselseitig ein- und wieder ausgeschaltet, wobei einer stets ausgeschaltet bleibt |

Es ist für den Fachmann ersichtlich, dass die Parametrierung nach der Erfindung grundsätzlich in Hardware und/oder in Software erfolgen kann.

Auch müssen die Aktoren nicht erst beide eingeschaltet werden, um einen Fehler zu erkennen, welches z.B. einen wesentlichen Vorteil gegenüber der TC5-PLCopen-Spezifikation bzw. EDM-Funktionsbausteinen bietet. Ferner ist der Aufbau eines modularen Systems, auch mit unterschiedlichen Sicherheitsniveaus, einschließlich einer explizit anwählbaren Verdrahtungsüberprüfung möglich. Darüber hinaus kann stets eine implizite Verdrahtungsüberprüfung gewährleistet werden. Ein hierzu bisher notwendiger, bewusster Fehlereinbau und wieder - ausbau entfällt. In den Steuerkanälen und in den Rücklesekreisen ist eine ortsgenaue Diagnose von dort auftretenden Fehlern sichergestellt und bisher unerkannt gebliebene Fehler werden sicher aufgedeckt.

## Patentansprüche

1. Verfahren zum Überprüfen der Funktionsfähigkeit von im Lastkreis einer Ausgangsschaltung zum Schalten des Lastkreises angeordneten Aktoren,
wobei die Aktoren Schütze oder Relais sind und jeweils eine Treibereinheit (10; 20) und Schließmittel (101; 201) besitzen,
wobei eine Anzahl von Aktoren (10, 101; 20, 201) im Lastkreis in Reihe angeordnet werden,
wobei die Treibereinheit (10; 20) jedes der Aktoren über einen separaten Steuerkanal (SK1; SK2) zur individuellen Ansteuerung mit einer Steuer- und Auswerteeinrichtung (SA) verbunden wird,
**dadurch gekennzeichnet, dass**
das Verfahren auch für eine Ausgangsschaltung zum Schalten von Motoren und zum separaten Überprüfen der Funktionsfähigkeit von einzelnen im Lastkreis angeordneten Aktoren durchgeführt wird,
wobei der Treibereinheit (10; 20) jedes der Aktoren ein Hilfskontakt (10H; 20H) zugeordnet wird,
wobei der jeweilige Hilfskontakt (10H; 20H) sich öffnet, wenn der zugeordnete Aktor (10, 101; 20, 201) aufgrund einer Ansteuerung durch die Steuer- und Auswerteeinrichtung (SA) aktiviert wird, und der Hilfskontakt (10H; 20H) sich schließt, wenn der zugeordnete Aktor (10, 101; 20, 201) aufgrund einer Ansteuerung durch die Steuer- und Auswerteeinrichtung (SA) deaktiviert wird,
und wobei die Hilfskontakte über wenigstens einen Rücklesekreis (RK; RK1, RK2) mit der Steuer- und Auswerteeinrichtung derart verbunden werden, dass nur bei Deaktivierung aller jeweils einem Rücklesekreis (RK; RK1, RK2) zugeordneten Aktoren über diesen Rücklesekreis ein Ruhesignal als Rücklesesignal von der Steuer- und Auswerteeinrichtung erfasst wird,
und wobei die Steuer- und Auswerteeinrichtung derart parametriert wird, dass das Ansteuern von in dem Lastkreis in Reihe angeordneten Aktoren zu deren Aktivierung die Schritte umfasst, dass in Bezug auf wenigstens einen Rücklesekreis (RK; RK1, RK2) zunächst immer nur ein zu diesem Rücklesekreis gehörender Aktor aktiviert und das über den diesem Aktor zugeordneten Rücklesekreis erfasste Rücklesesignal ausgewertet wird und zumindest einer von allen in dem Lastkreis in Reihe angeordneten Aktoren (10, 101; 20, 201) zumindest solange deaktiviert bleibt.

2. Verfahren nach vorstehendem Anspruch, wobei die Steuer- und Auswerteeinrichtung (SA) derart parametriert wird, dass bei geforderter Aktivierung aller in dem Lastkreis in Reihe angeordneten Aktoren (10, 101; 20, 201) vor der Aktivierung aller Aktoren und/oder bei nicht geforderter Aktivierung aller in dem Lastkreis in Reihe angeordneten Aktoren stets zumindest einer der in dem Lastkreis in Reihe angeordneten Aktoren (10, 101; 20, 201) deaktiviert bleibt und wobei in Bezug auf wenigstens einen Rücklesekreis (RK; RK1, RK2) jeweils lediglich ein zu diesem Rücklesekreis gehörender Aktor abwechselnd zur Aktivierung und Deaktivierung angesteuert wird, wobei währenddessen alle weiteren zu diesem Rücklesekreis gehörenden Aktoren deaktiviert bleiben und das entsprechend über den Rücklesekreis erfasste Rücklesesignal ausgewertet wird.

3. Verfahren nach einem der vorstehenden Ansprüche, ferner **dadurch gekennzeichnet, dass** bei jedem geforderten Aktivierungsvorgang aller in dem Lastkreis in Reihe geschalteten Aktoren (10, 101; 20, 201) mit der Aktivierung eines Aktors abgeschlossen wird, der beim vorangegangen Aktivierungsvorgang aller Aktoren nicht der letzte war, der hierzu aktiviert wurde.

4. Verfahren nach einem der vorstehenden Ansprüche, wobei in Bezug auf wenigstens einen Rücklesekreis (RK; RK1, RK2) beim jeweiligen Aktivieren lediglich eines zu einem Rücklesekreis gehörenden Aktors und/oder beim Deaktivieren aller zu einem gemeinsamen Rücklesekreis gehörender Aktoren das über den entsprechenden Rücklesekreis erfasste Rücklesesignal ausgewertet wird.

5. Verfahren nach einem der vorstehenden Ansprüche, wobei in Bezug auf wenigstens einen Rücklesekreis (RK; RK1, RK2) beim jeweiligen Aktivieren lediglich eines zu einem Rücklesekreis gehörenden Aktors und/oder beim Deaktivieren aller zu einem gemeinsamen Rücklesekreis gehörender Aktoren die Reaktionszeit eines über den entsprechenden Rücklesekreis erfassten Signalwechsels mit einem vordefinierten Zeitfensters verglichen wird.

6. Verfahren nach einem der vorstehenden Ansprüche 1 bis 5, wobei Hilfskontakte (10H; 20H), zweckmäßig jeweils zwei Hilfskontakte, in einer Reihenschaltung zur Bildung eines gemeinsamen Rücklesekreises (RK) mit der Steuer- und Auswerteeinrichtung (SA) verbunden werden.

7. Verfahren nach Anspruch 1, wobei jeder Hilfskontakt (10H; 20H) über einen separaten Rücklesekreis (RK1, RK2) mit der Steuer- und Auswerteeinrichtung (SA) verbunden wird.

8. Verfahren nach vorstehendem Anspruch 7, wobei die separaten Rücklesekreise (RK1, RK2) zur Auswertung in Art einer Reihenschaltung miteinander gekoppelt werden.

9. Steuer- und Auswertesystem zum Überprüfen von im Lastkreis einer Ausgangsschaltung zum Schalten des Lastkreises in Reihe angeordneten Aktoren, umfassend:
- eine Steuer- und Auswerteeinrichtung (SA), geeignet für ein Verfahren nach einem der vorstehenden Ansprüche 1 bis 8,
- eine Anzahl von Aktoren (10,101; 20,201), sowie von Steuerkanälen (SK1; SK2), die zum Steuern der Aktoren (10, 101; 20, 201) mit diesen verbunden sind,
- wobei die Aktoren Schütze oder Relais sind und jeweils eine Treibereinheit (10; 20) und Schließmittel (101; 201) besitzen, und wobei die Treibereinheit (10; 20) jedes der Aktoren über einen separaten Steuerkanal (SK1; SK2) zur individuellen Ansteuerung mit der Steuer- und Auswerteeinrichtung (SA) verbunden ist,
- und eine Anzahl von Rücklesekreisanschlüssen, die mit den Treibereinheiten (10; 20) der Aktoren zugeordneten Hilfskontakten (10H; 20H) verbunden sind, wobei die Hilfskontakte (10H; 20H) mittels der Rücklesekreisanschlüsse über wenigstens einen Rücklesekreis (RK; RK1, RK2) mit der Steuer- und Auswerteeinrichtung (SA) verbunden sind,
- wobei die Steuer- und Auswerteeinrichtung (SA) derart parametriert und/oder parametrierbar ist, dass,
bei in Reihenschaltung angeordneten Aktoren, der Treibereinheit jedem der Aktoren ein Hilfskontakt (10H;
20H) zugeordnet ist, der geöffnet ist, wenn der zugeordnete Aktor (10, 101; 20, 201) aufgrund einer Ansteuerung durch die Steuer- und Auswerteeinrichtung (SA) aktiviert ist, und der geschlossen ist, wenn der zugeordnete Aktor (10, 101; 20, 201) aufgrund einer Ansteuerung durch die Steuer- und Auswerteeinrichtung (SA) deaktiviert ist,
wobei nur bei Deaktivierung aller Aktoren, denen ein gemeinsamer Rücklesekreis zugeordnet ist, über diesen ein Ruhesignal als Rücklesesignal von der Steuer- und Auswerteeinrichtung (SA) erfassbar ist,
und beim Ansteuern von in einem Lastkreis in Reihe angeordneten Aktoren (10, 101; 20, 201) zu deren Aktivierung zunächst in Bezug auf wenigstens einen Rücklesekreis (RK; RK1, RK2) immer nur ein zu diesem Rücklesekreis gehörender Aktor aktiviert ist und das über den diesem Aktor zugeordneten Rücklesekreis erfasste Rücklesesignal ausgewertet ist, bevor zumindest der letzte der in dem Lastkreis in Reihe angeordneten Aktoren aktiviert werden kann.

10. Steuer- und Auswertesystem nach vorstehendem Anspruch 9, wobei die Steuer- und Auswerteeinrichtung (SA) derart parametriert und/oder parametrierbar ist, dass bei geforderter Aktivierung aller in dem Lastkreis in Reihe angeordneten Aktoren (10, 101; 20, 201) vor der Aktivierung aller Aktoren und/oder bei nicht geforderter Aktivierung aller in dem Lastkreis in Reihe angeordneten Aktoren stets zumindest einer der in dem Lastkreis in Reihe angeordneten Aktoren deaktiviert bleibt und wobei in Bezug auf wenigstens einen Rücklesekreis (RK; RK1, RK2) jeweils lediglich ein zu diesem Rücklesekreis gehörender Aktor abwechselnd zur Aktivierung und Deaktivierung ansteuerbar ist und das entsprechend über den Rücklesekreis erfasste Rücklesesignal auszuwerten ist, wobei währenddessen alle weiteren zu diesem Rücklesekreis gehörenden Aktoren deaktiviert bleiben.

11. Steuer- und Auswertesystem nach einem der vorstehenden Ansprüche 9 bis 10, wobei die Steuer- und Auswerteeinrichtung (SA) derart parametriert und/oder parametrierbar ist, jeden geforderten Aktivierungsvorgang aller in dem Lastkreis in Reihe geschalteten Aktoren (10, 101; 20, 201) mit der Aktivierung eines Aktors abzuschließen, der beim vorangegangen Aktivierungsvorgang aller Aktoren nicht der letzte war, der hierzu eingeschaltet worden ist.

12. Steuer- und Auswertesystem nach einem der vorstehenden Ansprüche 9 bis 11, wobei die Steuer- und Auswerteeinrichtung, der wenigstens eine Rücklesekreis (RK; RK1, RK2) und die Aktoren (10, 101; 20, 201) in einem Gehäuse integriert sind und/oder einzelne miteinander verbindbare Moduleinheiten sind.

13. Steuer- und Auswertesystem nach einem der vorstehenden Ansprüche 9 bis 12, wobei die Steuer- und Auswerteeinrichtung (SA) parametriert und/oder parametrierbar ist, in Bezug auf wenigstens einen Rücklesekreis (RK; RK1, RK2) beim jeweiligen Aktivieren lediglich eines zu einem Rücklesekreis gehörenden Aktors und/oder beim Deaktivieren aller zu einem gemeinsamen Rückleskreis gehörender Aktoren das über den entsprechenden Rücklesekreis erfasste Rücklesesignal auszuwerten.

14. Steuer- und Auswertesystem nach einem der vorstehenden Ansprüche 9 bis 13, wobei die Steuer- und Auswerteeinrichtung (SA) eine Vergleichseinrichtung besitzt, welche ausgebildet ist, in Bezug auf wenigstens einen Rücklesekreis beim jeweiligen Aktivieren lediglich eines zu einem Rücklesekreis gehörenden Aktors und/oder beim Deaktivieren aller zu einem gemeinsamen Rückleskreis gehörender Aktoren die Reaktionszeit eines über den entsprechenden Rücklesekreis (RK; RK1, RK2) detektierten Signalwechsels mit einem vordefinierten Zeitfensters zu vergleichen.

15. Steuer- und Auswertesystem nach einem der vorstehenden Ansprüche 9 bis 14, wobei Hilfskontakte (10H; 20H), zweckmäßig jeweils zwei Hilfskontakte, in einer Reihenschaltung zur Bildung eines gemeinsamen Rücklesekreises (RK) mit der Steuer- und Auswerteeinrichtung (SA) verbunden sind.

16. Steuer- und Auswertesystem nach einem der vorstehenden Ansprüche 9 bis 14, wobei jeder Hilfskontakt (10H; 20H) über einen separaten Rücklesekreis (RK1, RK2) mit der Steuer- und Auswerteeinrichtung (SA) verbunden ist.

17. Steuer- und Auswertesystem nach vorstehendem Anspruch 16, wobei die Steuer- und Auswerteeinrichtung (SA) ausgebildet und/oder ausbildbar ist, die separat mit der Steuer- und Auswerteeinrichtung verbundenen Rücklesekreise (RK1, RK2) zur Auswertung in Art einer Reihenschaltung miteinander zu koppeln,

18. Steuer- und Auswertesystem nach einem der vorstehenden Ansprüche 9 bis 17, wobei die Steuer- und Auswerteeinrichtung (SA) von extern zur Einleitung wenigstens eines Aktivierungsvorgangs ansteuerbar ist.

## Claims

1. Method for testing the functionality of actuators disposed in the load circuit of an output circuit for switching the load circuit,
wherein the actuators are contactors or relays and in each case have a driver unit (10; 20) and closure means (101; 201),
wherein a number of actuators (10, 101; 20, 201) are disposed in series in the load circuit,
wherein the driver unit (10; 20) of each of the actuators is connected to a control and evaluation device (SA) via a separate control channel (SKI; SK2) for the purposes of individual control,
**characterised in that**
the method is also implemented for an output circuit for switching motors and for separately testing the functionality of individual actuators disposed in the load circuit,
wherein an auxiliary contact (10H; 20H) is allocated to the driver unit (10; 20) of each of the actuators,
wherein the respective auxiliary contact (10H; 20H) opens when the associated actuator (10, 101; 20, 201) is activated owing to control by the control and evaluation device (SA), and the auxiliary contact (10H; 20H) closes when the associated actuator (10, 101; 20, 201) is deactivated owing to control by the control and eval uation device (SA),
and wherein the auxiliary contacts are connected to the control and evaluation device via at least one read-back circuit (RK; RK1, RK2) such that a quiescent signal is detected by the control and evaluation device as a read-back signal only upon deactivation of all of the actuators - allocated in each case to a read-back circuit (RK; RK1, RK2) - via this read-back circuit,
and wherein the control and evaluation device is parameterised such that the control of actuators disposed in series in the load circuit comprises, for the activation thereof, the steps that in relation to at least one read-back circuit (RK; RK1, RK2) initially always only one actuator belonging to this read-back circuit is activated and the read-back signal detected via the read-back circuit allocated to this actuator is evaluated and at least one of all of the actuators (10, 101; 20, 201) disposed in series in the load circuit remains deactivated for at least as long.

2. Method as claimed in the preceding claim, wherein the control and evaluation device (SA) is parameterised such that when all of the actuators (10, 101; 20, 201) disposed in series in the load circuit are required to be activated, prior to activation of all actuators, and/or when not all of the actuators disposed in series in the load circuit are required to be activated, at least one of the actuators (10, 101; 20, 201) disposed in series in the load circuit always remains deactivated, and wherein in relation to at least one read-back circuit (RK; RK1, RK2) in each case only one actuator belonging to this read-back circuit is controlled in an alternating manner for activation and deactivation, wherein meanwhile all further actuators belonging to this read-back circuit remain deactivated and the read-back signal correspondingly detected via the read-back circuit is evaluated.

3. Method as claimed in any one of the preceding claims, further **characterised in that** each required activation process of all of the actuators (10, 101; 20, 201) connected in series in the load circuit is concluded with the activation of an actuator which, during the preceding process of activating all of the actuators, was not the last to be activated for this purpose.

4. Method as claimed in any one of the preceding claims, wherein in relation to at least one read-back circuit (RK; RK1, RK2) in the case of respective activation of only one actuator belonging to a read-back circuit and/or in the case of deactivation of all of the actuators belonging to a common read-back circuit, the read-back signal detected via the corresponding read-back circuit is evaluated.

5. Method as claimed in any one of the preceding claims, wherein in relation to at least one read-back circuit (RK; RK1, RK2) in the case of respective activation of only one actuator belonging to a read-back circuit and/or in the case of deactivation of all of the actuators belonging to a common read-back circuit, the reaction time of a signal change detected via the corresponding read-back circuit is compared with a predefined time window.

6. Method as claimed in any one of the preceding Claims 1 to 5, wherein auxiliary contacts (10H; 20H), in an expedient manner two auxiliary contacts in each case, are connected to the control and evaluation device (SA) in a series connection to form a common read-back circuit (RK).

7. Method as claimed in Claim 1, wherein each auxiliary contact (10H; 20H) is connected to the control and evaluation device (SA) via a separate read-back circuit (RK1, RK2).

8. Method as claimed in the preceding Claim 7, wherein the separate read-back circuits (RK1, RK2) are coupled together in the manner of a series connection for the purposes of evaluation.

9. Control and evaluation system for testing actuators disposed in series in the load circuit of an output circuit for switching the load circuit, comprising:
- a control and evaluation device (SA) suitable for a method as claimed in any one of the preceding Claims 1 to 8,
- a number of actuators (10, 101; 20, 201) and of control channels (SKI; SK2) which are connected thereto for controlling the actuators (10, 101; 20, 201),
- wherein the actuators are contactors or relays and in each case have a driver unit (10; 20) and closure means (101; 201), and wherein the driver unit (10; 20) of each of the actuators is connected to the control and evaluation device (SA) via a separate control channel (SKI; SK2) for the purposes of individual control,
- and a number of read-back circuit connectors which are connected to auxiliary contacts (10H; 20H) allocated to the driver units (10; 20) of the actuators, wherein the auxiliary contacts (10H; 20H) are connected to the control and evaluation device (SA) by means of the read-back circuit connectors via at least one read-back circuit (RK; RK1, RK2),
- wherein the control and evaluation device (SA) is and/or can be parameterised such that
in the case of actuators disposed in series connection, an auxiliary contact (10H; 20H) is allocated to the driver unit of each of the actuators, which auxiliary contact is opened when the associated actuator (10, 101; 20, 201) is activated owing to control by the control and evaluation device (SA), and is closed when the associated actuator (10, 101; 20, 201) is deactivated owing to control by the control and evaluation device (SA),
wherein a quiescent signal can be detected by the control and evaluation device (SA) as a read-back signal only upon deactivation of all of the actuators - to which a common read-back circuit is allocated - via this read-back circuit,
and in the case of the control of actuators (10, 101; 20, 201) disposed in series in a load circuit, for the activation thereof, in relation to at least one read-back circuit (RK; RK1, RK2) initially always only one actuator belonging to this read-back circuit is activated and the read-back signal detected via the read-back circuit allocated to this actuator is evaluated before at least the last one of the actuators disposed in series in the load circuit can be activated.

10. Control and evaluation system as claimed in the preceding Claim 9, wherein the control and evaluation device (SA) is and/or can be parameterised such that when all of the actuators (10, 101; 20, 201) disposed in series in the load circuit are required to be activated, prior to activation of all actuators, and/or when not all of the actuators disposed in series in the load circuit are required to be activated at least one of the actuators disposed in series in the load circuit always remains deactivated, and wherein in relation to at least one read-back circuit (RK; RK1. RK2) in each case only one actuator belonging to this read-back circuit can be controlled in an alternating manner for activation and deactivation and the read-back signal correspondingly detected via the read-back circuit is to be evaluated, wherein meanwhile all further actuators belonging to this read-back circuit remain deactivated.

11. Control and evaluation system as claimed in any one of the precedi ng Claims 9 to 10, wherein the control and evaluation device (SA) is and/or can be parameterised so as to conclude each required activation process of all of the actuators (10, 101; 20, 201) connected in series in the load circuit with the activation of an actuator which, during the preceding process of activating all of the actuators, was not the last to be switched on for this purpose.

12. Control and evaluation system as claimed in any one of the preceding Claims 9 to 11, wherein the control and evaluation device, the at least one read-back circuit (RK; RK1, RK2) and the actuators (10, 101; 20, 201) are integrated in a housing and/or are individual modular units which can be connected together.

13. Control and evaluation system as claimed in any one of the preceding Claims 9 to 12, wherein the control and evaluation device (SA) is and/or can be parameterised to evaluate the read-back signal detected via the corresponding read-back circuit in relation to at least one read-back circuit (RK; RK1, RK2) in the case of respective activation of only one actuator belonging to a read-back circuit and/or in the case of deactivation of all of the actuators belonging to a common read-back circuit.

14. Control and evaluation system as claimed in any one of the preceding Claims 9 to 13, wherein the control and evaluation device (SA) has a comparing device which is formed, in relation to at least one read-back circuit in the case of respective activation of only one actuator belonging to a read-back circuit and/or in the case of deactivation of all of the actuators belonging to a common read-back circuit to compare the reaction time of a signal change detected via the corresponding read-back circuit (RK; RK1, RK2) with a predefined time window.

15. Control and evaluation system as claimed in any one of the preceding Claims 9 to 14, wherein auxiliary contacts (10H; 20H), in an expedient manner two auxiliary contacts in each case, are connected to the control and evaluation device (SA) in a series connection to form a common read-back circuit (RK).

16. Control and evaluation system as claimed in any one of the preceding Claims 9 to 14, wherein each auxiliary contact (10H; 20H) is connected to the control and evaluation device (SA) via a separate read-back circuit (RK1, RK2).

17. Control and evaluation system as claimed in the preceding Claim 16, wherein the control and evaluation device (SA) is and/or can be formed to couple the read-back circuits (RK1, RK2) - which are separately connected to the control and evaluation device - together in the manner of a series connection for the purposes of evaluation.

18. Control and evaluation system as claimed in any one of the preceding Claims 9 to 17, wherein the control and evaluation device (SA) can be controlled externally to initiate at least one activation process.

## Revendications

1. Procédé de contrôle de l'aptitude au fonctionnement d'actionneurs disposés dans le circuit de charge d'un circuit de sortie pour la commutation du circuit de charge,
lesdits actionneurs étant des contacteurs ou des relais comportant chacun une unité d'excitation (10 ; 20) et un moyen de fermeture (101 ; 201),
un certain nombre d'actionneurs (10, 101 ; 20 ; 201) étant disposés en ligne dans le circuit de charge,
l'unité d'excitation (10 ; 20) de chacun des actionneurs étant reliée à un dispositif de commande et d'évaluation (SA) par l'intermédiaire d'un canal de commande (SK1 ; SK2) séparé pour une excitation individuelle,
ledit procédé étant **caractérisé en ce que** :
il est également exécuté pour un circuit de sortie pour la commutation de moteurs et pour le contrôle séparé de l'aptitude au fonctionnement de différents actionneurs disposés dans le circuit de charge,
un contact auxiliaire (10H ; 20H) étant associé à l'unité d'excitation (10 ; 20) de chacun des actionneurs,
chaque contact auxiliaire (10H ; 20H) s'ouvrant quand l'actionneur (10, 101 ; 20 ; 201) correspondant est activé suite à une excitation par le dispositif de commande et d'évaluation (SA), et le contact auxiliaire (10H ; 20H) se fermant quand l'actionneur (10, 101 ; 20 ; 201) correspondant est désactivé suite à une excitation par le dispositif de commande et d'évaluation (SA), et
les contacts auxiliaires étant reliés au dispositif de commande et d'évaluation par l'intermédiaire d'au moins un circuit de rétro-lecture (RK ; RK1, RK2), de telle manière qu'un signal de repos est détecté comme signal de rétro-lecture par le dispositif de commande et d'évaluation, seulement en cas de désactivation de tous les actionneurs associés à un circuit de rétro-lecture (RK ; RK1, RK2) par l'intermédiaire dudit circuit de rétro-lecture,
et le dispositif de commande et d'évaluation étant paramétré de telle manière que l'excitation pour l'activation des actionneurs disposés en ligne dans le circuit de charge comprend les phases d'activation préalable, relativement à au moins un circuit de rétro-lecture (RK ; RK1, RK2), toujours d'un seul actionneur appartenant audit circuit de rétro-lecture et d'évaluation du signal de rétro-lecture détecté par l'intermédiaire du circuit de rétro-lecture associé audit actionneur, au moins un actionneur parmi tous les actionneurs (10, 101 ; 20 ; 201) disposés en ligne dans le circuit de charge restant désactivé au moins aussi longtemps.

2. Procédé selon la revendication précédente, dans lequel le dispositif de commande et d'évaluation (SA) est paramétré de telle manière qu'en cas d'activation demandée de tous les actionneurs (10, 101 ; 20 ; 201) disposés en ligne dans le circuit de charge préalablement à l'activation de tous les actionneurs et/ou en cas d'activation non demandée de tous les actionneurs disposés en ligne dans le circuit de charge, au moins un des actionneurs (10, 101 ; 20 ; 201) disposés en ligne dans le circuit de charge reste toujours désactivé, et dans lequel, relativement à au moins un circuit de rétro-lecture (RK ; RK1, RK2), un seul actionneur appartenant audit circuit de rétro-lecture est en alternance excité en activation et désactivation, tous les autres actionneurs appartenant audit circuit de rétro-lecture restant désactivés pendant ce temps, et le signal de rétro-lecture détecté en conséquence par l'intermédiaire du circuit de rétro-lecture étant évalué.

3. Procédé selon l'une des revendications précédentes, **caractérisé en outre en ce que** chaque processus d'activation demandé de tous les actionneurs (10, 101 ; 20 ; 201) montés en ligne dans le circuit de charge se termine par l'activation d'un actionneur qui, lors du processus d'activation précédent de tous les actionneurs, n'était pas le dernier à être activé à cet effet.

4. Procédé selon l'une des revendications précédentes, dans lequel, relativement à au moins un circuit de rétro-lecture (RK ; RK1, RK2) en cas d'activation respective d'un seul actionneur appartenant à un circuit de rétro-lecture et/ou en cas de désactivation de tous les actionneurs appartenant à un circuit de rétro-lecture commun, le signal de rétro-lecture détecté par l'intermédiaire du circuit de rétro-lecture correspondant est évalué.

5. Procédé selon l'une des revendications précédentes, dans lequel, relativement à au moins un circuit de rétro-lecture (RK ; RK1, RK2) en cas d'activation respective d'un seul actionneur appartenant à un circuit de rétro-lecture et/ou en cas de désactivation de tous les actionneurs appartenant à un circuit de rétro-lecture commun, le temps de réaction d'un changement de signal détecté par l'intermédiaire du circuit de rétro-lecture correspondant est comparé à une fenêtre temporelle définie.

6. Procédé selon l'une des revendications précédentes, dans lequel des contacts auxiliaires (10H ; 20H), fonctionnellement deux contacts auxiliaires, sont reliés au dispositif de commande et d'évaluation (SA) dans un montage en ligne pour former un circuit de rétro-lecture (RK) commun.

7. Procédé selon la revendication 1, dans lequel chaque contact auxiliaire (10H ; 20H) est relié au dispositif de commande et d'évaluation (SA) par un circuit de rétro-lecture (RK1, RK2) séparé.

8. Procédé selon la revendication 7, dans lequel les circuits de rétro-lecture (RK1, RK2) séparés sont couplés l'un à l'autre pour évaluation à la façon d'un montage en ligne.

9. Système de commande et d'évaluation pour le contrôle d'actionneurs disposés en ligne dans le circuit de charge d'un circuit de sortie pour la commutation du circuit de charge, comprenant :
- un dispositif de commande et d'évaluation (SA), prévu pour un procédé selon l'une des revendications 1 à 8,
- un certain nombre d'actionneurs (10, 101 ; 20 ; 201), et de canaux de commande (SK1, SK2) reliés aux actionneurs (10, 101 ; 20 ; 201) pour la commande ceux-ci,
- lesdits actionneurs étant des contacteurs ou des relais comportant chacun une unité d'excitation (10 ; 20) et un moyen de fermeture (101 ; 201), et l'unité d'excitation (10 ; 20) de chacun des actionneurs étant reliée à un dispositif de commande et d'évaluation (SA) par l'intermédiaire d'un canal de commande (SK1 ; SK2) séparé pour une excitation individuelle,
- et un certain nombre de connexions de circuits de rétro-lecture raccordées aux unités d'excitation (10 ; 20) des contacts auxiliaires (10H ; 20H) associés aux actionneurs, lesdits contacts auxiliaires (10H ; 20H) étant reliés au dispositif de commande et d'évaluation (SA) au moyen des connexions de circuits de rétro-lecture, par l'intermédiaire d'au moins un circuit de rétro-lecture (RK ; RK1, RK2),
- le dispositif de commande et d'évaluation (SA) étant paramétré et/ou paramétrable de telle manière :
qu'en cas d'actionneurs disposés en montage en ligne, un contact auxiliaire (10H ; 20H) est associé à l'unité d'excitation de chacun des actionneurs, lequel s'ouvre quand l'actionneur (10, 101 ; 20 ; 201) correspondant est activé suite à une excitation par le dispositif de commande et d'évaluation (SA), et se ferme quand l'actionneur (10, 101 ; 20 ; 201) correspondant est désactivé suite à une excitation par le dispositif de commande et d'évaluation (SA),
un signal de repos pouvant être détecté comme signal de rétro-lecture par le dispositif de commande et d'évaluation (SA), seulement en cas de désactivation de tous les actionneurs auxquels est associé un circuit de rétro-lecture commun par l'intermédiaire dudit circuit de rétro-lecture,
et l'excitation pour l'activation des actionneurs (10, 101 ; 20 ; 201) disposés en ligne dans un circuit de charge activant au préalable, relativement à au moins un circuit de rétro-lecture (RK ; RK1, RK2), toujours un seul actionneur appartenant audit circuit de rétro-lecture, le signal de rétro-lecture détecté par l'intermédiaire du circuit de rétro-lecture associé audit actionneur étant évalué, avant qu'au moins le dernier des actionneurs disposés en ligne dans le circuit de charge puisse être activé.

10. Système de commande et d'évaluation selon la revendication 9, dans lequel le dispositif de commande et d'évaluation (SA) est paramétré et/ou paramétrable de telle manière qu'en cas d'activation demandée de tous les actionneurs (10, 101 ; 20 ; 201) disposés en ligne dans le circuit de charge préalablement à l'activation de tous les actionneurs et/ou en cas d'activation non demandée de tous les actionneurs disposés en ligne dans le circuit de charge, au moins un des actionneurs disposés en ligne dans le circuit de charge reste toujours désactivé, et dans lequel, relativement à au moins un circuit de rétro-lecture (RK ; RK1, RK2), un seul actionneur appartenant audit circuit de rétro-lecture peut être en alternance excité en activation et désactivation, le signal de rétro-lecture détecté en conséquence par l'intermédiaire du circuit de rétro-lecture devant être évalué, tous les autres actionneurs appartenant audit circuit de rétro-lecture restant désactivés pendant ce temps.

11. Système de commande et d'évaluation selon la revendication 9 ou la revendication 10, dans lequel le dispositif de commande et d'évaluation (SA) est paramétré et/ou paramétrable pour terminer chaque processus d'activation demandé de tous les actionneurs (10, 101 ; 20 ; 201) montés en ligne dans le circuit de charge par l'activation d'un actionneur qui, lors du processus d'activation précédent de tous les actionneurs, n'était pas le dernier à être activé à cet effet.

12. Système de commande et d'évaluation selon l'une des revendications 9 à 11, dans lequel le dispositif de commande et d'évaluation, l'au moins un circuit de rétro-lecture (RK ; RK1, RK2) et les actionneurs (10, 101 ; 20 ; 201) sont intégrés à un boîtier et/ou sont des unités modulaires individuelles raccordables entre elles.

13. Système de commande et d'évaluation selon l'une des revendications 9 à 12, dans lequel le dispositif de commande et d'évaluation (SA) est paramétré et/ou paramétrable pour que, relativement à au moins un circuit de rétro-lecture (RK ; RK1, RK2) en cas d'activation respective d'un seul actionneur appartenant à un circuit de rétro-lecture et/ou en cas de désactivation de tous les actionneurs appartenant à un circuit de rétro-lecture commun, le signal de rétro-lecture détecté par l'intermédiaire du circuit de rétro-lecture correspondant soit évalué.

14. Système de commande et d'évaluation selon l'une des revendications 9 à 13, dans lequel le dispositif de commande et d'évaluation (SA) comprend un dispositif comparateur réalisé pour que, relativement à au moins un circuit de rétro-lecture en cas d'activation respective d'un seul actionneur appartenant à un circuit de rétro-lecture et/ou en cas de désactivation de tous les actionneurs appartenant à un circuit de rétro-lecture commun, le temps de réaction d'un changement de signal détecté par l'intermédiaire du circuit de rétro-lecture (RK ; RK1, RK2) correspondant soit comparé à une fenêtre temporelle définie.

15. Système de commande et d'évaluation selon l'une des revendications 9 à 14, dans lequel des contacts auxiliaires (10H ; 20H), fonctionnellement deux contacts auxiliaires, sont reliés au dispositif de commande et d'évaluation (SA) dans un montage en ligne pour former un circuit de rétro-lecture (RK) commun.

16. Système de commande et d'évaluation selon l'une des revendications 9 à 14, dans lequel chaque contact auxiliaire (10H ; 20H) est relié au dispositif de commande et d'évaluation (SA) par un circuit de rétro-lecture (RK1, RK2) séparé.

17. Système de commande et d'évaluation selon la revendication 16, dans lequel le dispositif de commande et d'évaluation (SA) est réalisé et/ou peut être réalisé pour coupler l'un à l'autre les circuits de rétro-lecture (RK1, RK2) séparément reliés au dispositif de commande et d'évaluation, pour évaluation à la façon d'un montage en ligne.

18. Système de commande et d'évaluation selon l'une des revendications 9 à 17, dans lequel le dispositif de commande et d'évaluation (SA) peut être excité de l'extérieur pour le déclenchement d'au moins un processus d'activation.
